Europäisches Patentamt

European Patent Office

Office européen des brevets

(19)

(11) **EP 0 587 606 B1**

(12) **EUROPÄISCHE PATENTSCHRIFT**

(45) Veröffentlichungstag und Bekanntmachung des Hinweises auf die Patenterteilung:
**02.05.1997 Patentblatt 1997/18**

(51) Int Cl.$^6$: **H03K 17/732**

(86) Internationale Anmeldenummer:
**PCT/EP92/01101**

(21) Anmeldenummer: **92910568.2**

(22) Anmeldetag: **19.05.1992**

(87) Internationale Veröffentlichungsnummer:
**WO 92/22138 (10.12.1992 Gazette 1992/31)**

(54) **SCHALTERANORDNUNG MIT TRANSISTOREN**

SWITCHING ARRANGEMENT WITH TRANSISTORS

MONTAGE COMMUTATEUR A TRANSISTORS

(84) Benannte Vertragsstaaten:
**AT BE CH DE FR GB IT LI NL**

(30) Priorität: **03.06.1991 DE 4118148**

(43) Veröffentlichungstag der Anmeldung:
**23.03.1994 Patentblatt 1994/12**

(73) Patentinhaber: **jerfy, Franz**
**D-80807 München (DE)**

(72) Erfinder: **jerfy, Franz**
**D-80807 München (DE)**

(56) Entgegenhaltungen:
**US-A- 4 833 587        US-A- 5 021 694**

- **PATENT ABSTRACTS OF JAPAN vol. 13, no. 218 (E-761)22 May 1989 & JP-A-1 029 113 (NEC CORP) 31 January 1989**
- **PATENT ABSTRACTS OF JAPAN vol. 13, no. 195 (E-754)10 May 1989 & JP-A-1 014 963 (NEC CORP) 19 January 1989**
- **PATENT ABSTRACTS OF JAPAN vol. 13, no. 285 (E-780)29 June 1989 & JP-A-1 069 118 (NEC CORP) 15 March 1989**
- **PATENT ABSTRACTS OF JAPAN vol. 13, no. 51 (E-712)6 February 1989 & JP-A-63 244 929 (NEC CORP) 12 October 1988**
- **ELECTRONIC ENGINEERING Vol. 42, No. 506, April 1970, LONDON GB pages 57 - 60; B.RAKOVICH ET AL.: 'a wide range linear time delay circuit'**

**Beschreibung**

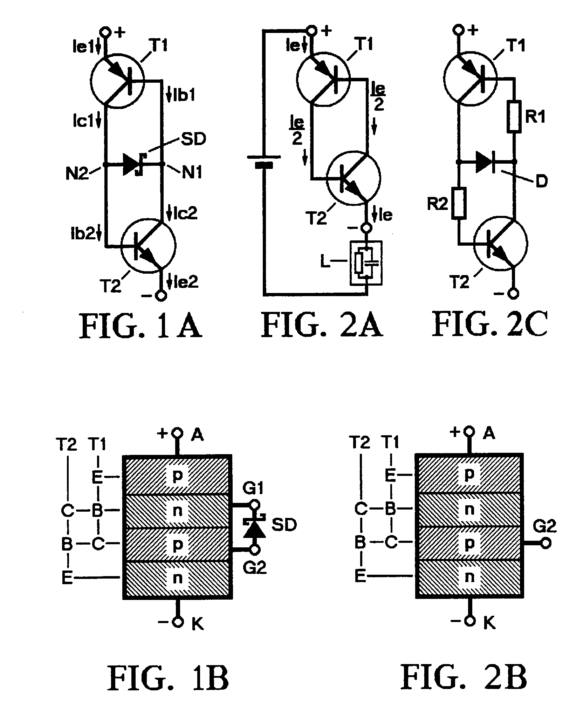

Die Erfindung betrifft eine Anordnung von zwei bipolaren Transistoren komplementärer Zonenfolge und einer Diode zum schnellen Schalten elektrischer Ströme und Spannungen insbesondere bei kapazitiven und ohmschen Lasten oder zur schnellen Umladung von Kapazitäten. Aus der Grundschaltung werden mehrere Varianten sowie zusammengesetzte Strukturen entwickelt. Die erfindungsgemäße Anordnung ist aus der bekannten Schaltung gemäß Fig. 2A abgeleitet.

Letztere besteht aus je einem Transistor vom Typ pnp und npn, die so verschaltet sind, daß der Kollektor des pnp-Transistors T1 mit der Basis des npn-Transistors T2, der Kollektor des npn-Transistors seinerseits mit der Basis des pnp-Transistors verbunden sind.

Wird der Emitter von T1 an eine positive oder der Emitter von T2 an eine negative Spannung gelegt und der andere Emitter über einen Lastwiderstand L mit dem zweiten Pol der Spannungsquelle verbunden, so wird die Anordung plötzlich leitend, sobald ein Strom geeigneter Polarität in die Basis eines der beiden Transistoren injiziert wird. Der injizierte Strom wird im Kollektorkreis des betreffenden Transistors vielfach verstärkt und fließt direkt in die Basis des anderen Transistors, der ihn seinerseits verstärkt in die Basis des ersten Transistors zurückleitet.

Eine besondere Eigenschaft dieser Schaltung besteht darin, daß sich die Ströme in den beiden Kollektor-Basis-Zweigen während der sog. regenerativen Phase, d.h. während des Durchschaltvorgangs, gegenseitig mit einer Zeitkonstante aufschaukeln, die direkt durch die Grenzfrequenz der Transistoren bestimmt wird und somit die kürzeste mit den Transistoren erreichbare Schaltzeit überhaupt darstellt. Ferner genügt zur Auslösung des Schaltvorgangs ein sehr kurzer und schwacher Stromimpuls, da fast die gesamte zur Ansteuerung der Anordnung erforderliche Energie dem Laststromkreis entnommen wird und nicht von besonderen Ansteuerschaltungen bereitgestellt werden muß.

Sind in der darauf folgenden statischen Phase beide Transistoren durchgeschaltet, so halten sie diesen Zustand von selbst aufrecht, solange ein Strom durch die Schalteranordnung fließt. Durch diesen Gedächtnis- bzw. Hystereseeffekt kann die Anordnung daher auch als Schalter mit Selbsthaltefunktion, Informationsspeicher oder als Schmitt-Trigger zur Impulsformung verwendet werden.

Falls in der Anordnung nach Fig. 2A beide Transistoren genau symmetrisch sind, so sind es die Ströme in den beiden Kollektor-Basis-Zweigen ebenfalls, das heißt in jedem der Zweige fließt die Hälfte des gesamten Stromes. Weil dieser Strom aber der Basis jedes Transistors aufgebürdet wird, wird die Basisschicht mit Minoritätsträgern überschwemmt und beide Transistoren befinden sich weit im Sättigungsbereich.

Der größte Nachteil der Schaltung, der ihre praktische Anwendbarkeit einschränkt, ist der Umstand, daß es schwierig ist, sie von dem eingeschalteten in den ausgeschalteten Zustand zu versetzen. Hierzu muß entweder mindestens einer der Ströme in den Kollektor-Basis-Zweigen unterbrochen oder die an der Schalteranordnung abfallende Spannung unter die kleinste Sättigungsspannung, bei der noch ein Strom durch den Schalter fließt, abgesenkt werden. Beides erfordert zusätzliche Schaltelemente, die etwa ebenso leistungsfähig sein müssen wie der beschriebene Schalter selbst. Im Gegensatz zum Einschaltvorgang, der in der kürzestmöglichen Zeit abläuft, muß beim Ausschaltvorgang die Unterbrechung des Stromes bzw. die Spannungsabsenkung an den Schaltelementen während der sogenannten Freiwerdezeit anhalten, die wegen der starken Sättigung sehr lang ist.

Der Zusammenschaltung zweier komplementärer Transistoren nach Fig. 2A entspricht ein Vierschichtelement mit drei Zonenübergängen gemäß Fig. 2B. Ein solches Bauteil ist unter dem Namen Thyristor bekannt und weist ähnliche Eigenschaften auf wie die Schaltung nach Fig. 2A. Hierbei ist der Emitter des pnp-Transistors T1 die Anode, der Emitter des npn-Transistors T2 die Kathode des Thyristors. Außerdem ist in der Regel die Verbindung des Kollektors von T1 mit der Basis von T2 als Steuerelektrode G2 herausgeführt.

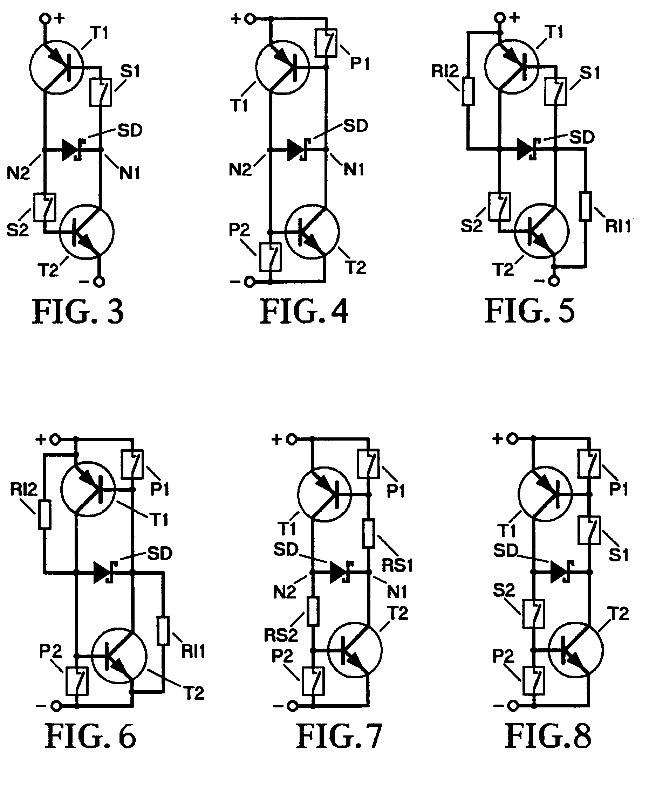

Die oben erwähnten Nachteile der Sättigung und der damit verbundenen Freiwerdezeit nach Beendigung des durchgeschalteten Zustandes wurden bisher beim Thyristor durch Erzeugung von Störstellenniveaus mittels Einbringung von Goldatomen in beide mittlere Schichten zur Erhöhung der Rekombinationsrate der Minoritätsträger oder durch Integration von Ableitwiderständen zwischen den beiden Emitter-Basiszonen zur Ableitung der überschüssigen Minoritätsträger zu den Emittern auf Kosten der Schaltgeschwindigkeit und Zündempfindlichkeit in Grenzen gehalten. Außerdem ist es üblich, zur Verkürzung der Freiwerdezeit sogenannte Ausräumschaltungen vorzusehen, die beim Abschalten einen Strom in die Steuerelektrode injizieren, dessen Polarität der des Zündstromes entgegengesetzt ist. Hierdurch wird die Entfernung der Überschußladungsträger aus den beiden mittleren Schichten beschleunigt. Es wurde ferner in Electronics, November 24, 1962, S. 42-46, Fig. 1A und in Electronic Engineering, Vol. 42, April 1970, Nr. 506 S. 57-60, Fig. 6 eine Anordnung gemäß Fig. 2C vorgeschlagen, bei der zwischen den Kollektoren der Transistoren T1 und T2 eine Diode D angeordnet ist und jeweils zwischen der Basis des einen Transistors und dem Verbindungspunkt des Kollektors des anderen Transistors mit der Diode D Widerstände R1 bzw. R2 von ca. 1 kΩ vorgesehen sind, wobei die Diode D leitend wird, wenn die Anordnung durchschaltet.

Bei dieser Lösung zerfällt der Durchschaltvorgang in zwei aufeinanderfolgende Phasen. Während der regenerativen ersten Phase nimmt der Strom durch die Widerstände R1 und R2 und damit der Spannungsabfall an denselben zu, während der Betrag der Kollektorspannung beider Transistoren wie auch die Sperrspannung an der Diode D im selben Maß abnimmt. Hierbei ist die Geschwindigkeit des Stromanstiegs wegen der Widerstände R1 und R2 in beiden Transistoren wesentlich geringer, als ihre Grenzfrequenz dies zuließe. Hat die Spannung an der Diode D den Wert der Durchlaßspannung erreicht, so beginnt diese zu leiten und beendet die erste Phase mit dem regenerativen Stromanstieg. Zu diesem Zeitpunkt ist die Anordnung bei niederohmiger oder kapazitiver Last noch nicht durchgeschaltet und der Laststrom besteht lediglich aus der Summe der Basis-ströme beider Transistoren. Wenn die Diode D leitend wird, kann die Kollektorspannung der Transistoren nur dann weiter abnehmen, wenn die Spannung längs der Last und damit auch der Laststrom zunehmen. Dies führt zu einem sprungartigen Anstieg der Ströme durch die Kollektoren sowie die Diode D und damit auch durch die Last. Sobald die Spannung längs der Last steigt, sinkt die Spannung längs der Schalteranordnung und damit auch längs der Widerstände R1 und R2, was zu einer Abnahme der Basisströme in den Transistoren führt. Der Gleichgewichtszustand ist erreicht, wenn die Basisströme der Transistoren gerade zur Aufrechterhaltung der jeweiligen Kollektorströme ausreichen. Der nun durch den Schalter fließende Strom ruft an diesem einen stromproportionalen Spannungsabfall hervor, dh. die Anordnung verhält sich jetzt gegenüber der Last wie ein mehr oder weniger niederohmiger Widerstand.

Die Aufgabe der vorliegenden Erfindung ist das schnelle Schalten niederohmiger, kapazitiver oder kapazitätsbehafteter Lasten. Es ist offensichtlich, daß die Lösungen nach dem Stand der Technik erhebliche Nachteile haben, insbesondere wenn beabsichtigt ist, die Anordnung als Bauteil für eine breite Palette von Anwendungen in integrierter Form herzustellen. Die größere Zahl von Komponenten erschwert die Integration wesentlich. Als Vierschichtelement kann die Anordnung nach Fig. 2C nicht realisiert werden, da bei diesem der Kollektor des einen Transistors mit der Basis des anderen identisch ist, ein Widerstand zwischen diesen sich daher nicht anordnen läßt.

Es hat sich nun gezeigt, daß Sättigungserscheinungen in obenbeschriebenen regenerativen Anordnungen zuverlässig unterdrückt werden können, wenn erfindungsgemäß nach Fig. 1A unter Wegfall der Widerstände R1 und R2 eine Diode SD, deren Flußspannung wesentlich kleiner ist als der Spannungsabfall an einem gewöhnlichen pn-Übergang der Transistoren, parallel zu den beiden Kollektor-Basis-Strecken der Transistoren T1 und T2 geschaltet wird und die so gepolt ist, daß sie leitend wird, wenn die Kollektor-Emitterspannung beider Transistoren unter das Basis-Emitterpotential sinkt. Wegen der prinzipiellen Ähnlichkeit der Kennlinie einer solchen Diode mit der eines pn-Übergangs im Transistor bei gleichzeitig wesentlich niedrigerer Schleusenspannung ergibt sich nämlich bei allen Laststromwerten eine hinreichende Differenz der Flußspannungen von Diode und pn-Übergängen in den Transistoren, um Sättigungserscheinungen in letzteren zu verhindern.

Wegen des Fehlens der 1 kΩ - Widerstände in den Basiszuleitungen wird die Geschwindigkeit des regenerativen Stromanstiegs wie bei der Anordnung gemäß Fig. 2A nur von der Grenzfrequenz der Transistoren begrenzt. Außerdem erstreckt sich die regenerative Phase auf den gesamten Umladevorgang der Lastkapazität bis zu dem Punkt, an dem die Restspannung an der Schalteranordnung erreicht ist. Der Innenwiderstand der Schalteranordnung im durchgeschalteten Zustand wird im wesentlichen von den Bahnwiderständen der im Stromflußpfad befindlichen Halbleiter bestimmt und ist somit sehr niedrig.

In der Praxis erfüllt beispielsweise eine Schottky-Diode oder - bei Verwendung von Siliziumtransistoren - eine Germaniumdiode obige Voraussetzung. Der gleiche Effekt läßt sich erzielen, wenn mindestens einer der beiden Transistoren T1 oder T2 als Schottky-Transistor ausgebildet d.h. seinem Kollektor-Basis-Übergang ein Schottky-Kontakt parallelgeschaltet wird. Zugleich mit der Vermeidung der Sättigung der beiden Transistoren tritt, wie aus Fig. 1A ersichtlich, an den Knotenpunkten N1 und N2 eine Stromverzweigung ein, sodaß in den Basiszweigen der beiden Transistoren T1 und T2 nur noch Ströme Ibl und Ib2 fließen, wie sie für die Aufrechterhaltung der jeweiligen Kollektorströme Ic1 und Ic2 entsprechend der Stromverstärkung β jedes Transistors gemäß der Formel

$$Ic = Ib * \beta \qquad (1)$$

erforderlich sind.

Der Hauptanteil des Stromes durch die Schalteranordnung fließt im durchgeschalteten Zustand durch Emitter und Kollektor von T1, die Diode SD sowie Kollektor und Emitter von T2 in die Last und nicht mehr wie in Fig. 2A durch die Basen von T1 und T2. Hierdurch wird nicht nur die starke Sättigung, wie sie in der Schaltung nach Fig. 2A auftritt, vermieden, sondern die Anordnung läßt sich auch viel leichter steuern, da jetzt nur noch die wesentlich schwächeren Basisströme geschaltet werden müssen. Wegen des Fehlens der Sättigungserscheinungen beträgt die Abschaltzeit nur einen Bruchteil der Freiwerdezeit der gesättigten Anordnung und ist von der gleichen Größenordnung wie die Einschaltzeit.

Wie in Fig. 1B dargestellt, läßt sich die erfindungsgemäße Anordnung auch vorteilhaft mit einem oben erwähnten Vierschichtelement gemäß Fig. 2B verwirklichen.

Sofern auch die Verbindung des Kollektors von T2 mit der Basis von T1 als Steuerelektrode G1 von außen zugänglich ist, kann die erfindungsgemäße Anordnung gemäß Fig. 1B mit einem solchen Bauteil realisiert werden, indem man eine geeignete Diode zwischen die beiden Kollektor-Basis-Zonen schaltet. Da Schottky-Dioden Metall-Halbleiter-Übergänge sind, läßt sich auf die gleiche Weise wie beim Schottky-Transistor alternativ eine Schottky-Diode nach Fig. 1B bereits in das Bauteil integrieren.

Die Anordnungen nach Fig. 1A oder Fig. 1B sind direkt in Schaltungen verwendbar, in denen der Strom durch die Lastimpedanz oder die Spannung längs der Schalteranordnung von selbst unter die zur Aufrechterhaltung des durchgeschalteten Zustandes erforderlichen Werte sinkt. In diesem Fall kann nach Unterschreitung der besagten Werte ein neuer Schaltzyklus begonnen werden, indem man erneut einen Strom in die Basis von T1 oder T2 injiziert, ohne eine Freiwerdezeit abwarten zu müssen.

Ordnet man, um die Schalteranordnung zu steuern, gemäß Fig. 3 in einem oder beiden der Basiszweige, d. h. zwischen den Knotenpunkten N1 oder N2 und den Basen von T1 oder T2 Schaltelemente S1 bzw. S2 an, so müssen diese Schaltelemente lediglich so stark ausgelegt sein, daß sie auf Dauer den maximal auftretenden Basisstrom schalten können. Dieser ist wegen Formel (1) gegeben durch

$$Ib = Ic/\beta \qquad (1a)$$

Typische Werte für Ic sind Ströme zwischen 100 mA und 10 A, für $\beta$ gelten Werte zwischen 10 und 100. Somit bewegt sich Ib im Bereich von 1 mA und 1 A. Ein Schalttransistor, der diese Ströme schalten kann und seinerseits über eine Stromverstärkung von 100 verfügt, benötigt lediglich einen Basisstrom von 10 uA bis 10 mA, um die Anordnung nach Fig. 3 ein- und auszuschalten. Um die Schalteranordnung einzuschalten, müssen S1 und gegebenenfalls S2 leitend sein. Um die Anordnung auszuschalten, genügt es, S1 oder S2 zu sperren. Da T1 und T2 jetzt nicht im Sättigungsbereich arbeiten, geschieht das Abschalten ähnlich schnell wie das Einschalten.

Alternativ kann man nach Fig. 4 aktive Schaltelemente P1 oder P2 parallel zu einer der Emitter-Basis-Strecken von T1 oder T2 anordnen. Im Gegensatz zu den Schaltelementen S1 und S2 von Fig. 3 müssen diese beim Einschaltvorgang sperren, damit der Basisstrom in die Basen von T1 und T2 fließen kann. Leiten P1 oder P2, so wird der betreffende Basisstrom zum Emitter abgeleitet, der entsprechende Transistor sperrt und die Schalteranordnung geht in den nichtleitenden Zustand über.

Fig. 5 und 6 zeigen beispielhaft die Möglichkeit, durch Betätigung der Schaltelemente S1, S2, P1 oder P2 Ströme in die Basen der Transistoren T1 oder T2 zu injizieren. Leitet das Schaltelement S1 in Fig. 5 oder sperrt das Schaltelement P1 in Fig. 6, so wird über den Widerstand RI1 ein Strom in die Basis von T1 injiziert. Durch die Betätigung von S2 oder die Sperrung von P2 kann über RI2 ein Strom in die Basis von T2 injiziert werden.

Bei der Anordnung nach Fig. 4 müssen die Schaltelemente P1 oder P2 bei Betätigung den Kollektorstrom der Transistoren T2 beziehungsweise T1 bis zur Sperrung dieser Transistoren ebenfalls übernehmen. Dies kann vermieden werden, wenn man gemäß Fig. 7 Widerstände RS1 und RS2 zwischen die Punkte N1 und Basis von T1 beziehungsweise N2 und Basis von T2 einfügt, die so bemessen sind, daß der Kollektorstrom von T2 beziehungsweise T1 an ihnen einen Spannungsabfall von mindestens 1 V hervorrufen würde. In diesem Fall müssen P1 oder P2 zusätzlich zu den Basisströmen lediglich etwa 10% des Kollektorstromes kurzzeitig übernehmen.

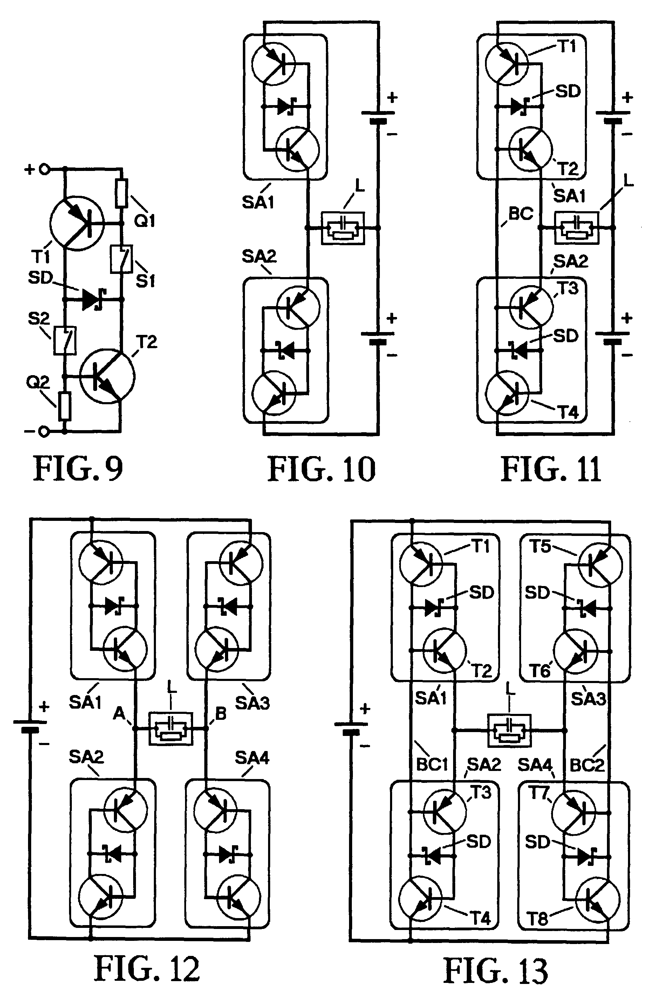

Aus schaltungstechnischen Gründen kann außerdem eine bestimmte Kombination aus Schaltelementen S1, S2, P1 und P2, wie in Fig. 8 dargestellt, vorteilhaft sein. Ferner kann es von Vorteil sein, gemäß Fig. 9 aktive Schaltelemente S1 oder S2 in der Basiszuleitung mit passiven Ableitelementen Q1 oder Q2 parallel zu den Basis-Emitterstrecken zu kombinieren, um sicherzustellen, daß die Kollektor-Basis-Restströme von T1 und T2 oder Restströme von S1 und S2 keinen Durchschaltvorgang auslösen können.

In der Praxis können die aktiven Schaltelemente S1 und S2 bzw. Ableitelemente P1 und P2 aus bipolaren Transistoren, Feldeffekttransistoren, Thyristoren, Triacs, Fototransistoren, Fotodioden, Fotowiderständen, Optokopplern usw. bestehen. Die passiven Impedanzen RS1, RS2, Q1 oder Q2 können aus einer Kombination von konzentrierten oder verteilten, linearen oder nichtlinearen Widerständen, Induktivitäten und Kapazitäten oder daraus bestehenden Netzwerken aufgebaut sein.

Die beschriebenen Schalteranordnungen können als unipolare elektronische Schalter direkt in Serie oder parallel zu einer Lastimpedanz arbeiten. Um bipolare Schalteigenschaften zu erzielen, können bei Vorhandensein einer bipolaren Spannungsversorgung zwei der obenbeschriebenen und in Fig. 1A, 1B, 3, 4, 5, 6, 7, 8 und 9 dargestellten Schalteranordnungen in Serie geschaltet werden. Fig. 10 oder Fig. 11 stellen zwei Beispiele einer solchen Halbbrückenschaltung dar, wobei jeweils nur eine der Schalteranordnungen SA1 oder SA2 leiten darf. Je nachdem, ob die obere oder die untere Schalteranordnung leitet, wird die Lastimpedanz L zur positiven oder negativen Speisespannung durchgeschaltet. Da bei dieser Konfiguration das gleichzeitige Einschalten beider Schalter einen Kurzschluß auslösen würde, ist es vorteilhaft, die Basen der beiden mittleren Transistoren T2 und T3 gemäß Fig. 11 durch die Verbindung BC zu verbinden. Hierdurch wird sichergestellt, daß immer nur eine der beiden Schalteranordnungen SA1 oder SA2 leitet.

Schließlich ist es möglich, zwei Halbbrücken nach Fig. 10 oder Fig. 11 zu einer Brückenschaltung gemäß Fig. 12 zusammenzufassen, um bei unipolarer Spannungsversorgung eine Last L bipolar betreiben zu können. Werden die Schalteranordnungen SA1 und SA4 gleichzeitig leitend, so wird Anschlußpunkt A der Lastimpedanz L mit dem positiven, der Anschlußpunkt B mit dem negativen Pol der Speisespannung verbunden. Umgekehrt liegen, wenn die Schalteranordnungen SA2 und SA3 betätigt sind, der Anschlußpunkt A am negativen, der Anschlußpunkt B am positiven Pol der Speisespannung. Auch bei der Brückenschaltung ist es vorteilhaft, durch die Verbindungen BC1 und BC2 gemäß Fig. 13 sicherzustellen, daß jeweils nur eine Schalteranordnung pro Brückenhälfte leitend ist.

Die vorbeschriebenen Schalteranordnungen bewirken insbesondere bei kapazitiven Lasten wie den Eingängen von MOSFETs und IGBTs, Leucht- und Laserdioden sowie Datenleitungen in Bussystemen extrem kurze Schaltzeiten. Da sie die zur Ansteuerung benötigte Energie im wesentlichen dem Laststromkreis entnehmen, genügt ein sehr schwacher Strom zur Auslösung des Schaltvorganges. Bei richtiger Dimensionierung der Schaltelemente werden trotz der gegenüber der Anordnung nach Fig. 2A erhöhten Komplexität keine erheblich verlängerten Einschaltzeiten beobachtet.

## Patentansprüche

1. Schalteranordnung mit Transistoren und regenerativer Stromrückkopplung, bestehend aus einem pnp-Transistor (T1) und einem npn-Transistor (T2), bei der der Emitter des pnp-Transistors die Anode, der Emitter des npn-Transistors die Kathode bildet, ferner der Kollektor des pnp-Transistors über einen ersten Verbindungspunkt (N2) mit der Basis des npn-Transistors, der Kollektor des npn-Transistors über einen zweiten Verbindungspunkt (N1) mit der Basis des pnp-Transistors verbunden ist, sowie einer Diode (SD), die zwischen den beiden Kollektor-Basis-Verbindungspunkten (N1, N2) angeordnet ist, wobei die Anode der Diode (SD) direkt mit dem Kollektor des pnp-Transistors (T1), die Kathode der Diode (SD) direkt mit dem Kollektor des npn-Transistors (T2) in Verbindung steht, **dadurch gekennzeichnet**, daß die Flußspannung der Diode (SD) wesentlich kleiner ist als der Spannungsabfall in Durchlaßrichtung an einem der pn-oder np-Übergänge der Transistoren (T1, T2).

2. Schalteranordnung nach Anspruch 1), **dadurch gekennzeichnet**, daß sie aus einer Halbleiteranordnung mit vier abwechselnden Zonen entgegengesetzten Leitungstyps gebildet wird, mit einer äußeren p-Emitterzone als Anode (A), einer inneren n-Kollektor-Basiszone, die als erste Steuerelektrode (G1) herausgeführt sein kann, einer inneren p-Kollektor-Basiszone, die als zweite Steuerelektrode (G2) herausgeführt sein kann und einer äußeren n-Emitterzone als Kathode (K), wobei die Diode (SD), deren Kathode mit der inneren n-Kollektor-Basiszone und deren Anode mit der inneren p-Kollektor-Basiszone verbunden ist, entweder von außen an die beiden als Steuer- oder Hilfselektroden (G1, G2) herausgeführten inneren n- und p-Kollektor-Basiszonen angeschlossen oder in entsprechender Weise zwischen diesen beiden Zonen direkt in in den die Halbleiteranordnung bildenden Halbleiterkristall integriert ist.

3. Schalteranordnung nach Anspruch 1), **dadurch gekennzeichnet**, daß zwischen dem ersten Verbindungspunkt (N2) und der Basis des npn-Transistors (T2) ein aktives Schaltelement (S2) angeordnet ist oder zwischen dem zweiten Verbindungspunkt (N1) und der Basis des pnp-Transistors (T1) ein aktives Schaltelement (S1) angeordnet ist oder an beiden besagten Stellen aktive Schaltelemente (S1,S2) angeordnet sind.

4. Schalteranordnung nach Anspruch 1) oder 2), **dadurch gekennzeichnet**, daß zwischen der Basis und dem Emitter des pnp-Transistors (T1) oder der Anode (A) und der n-Kollektor-Basiszone der Halbleiteranordnung ein aktives Schaltelement (P1) oder zwischen der Basis und dem Emitter des npn-Transistors (T2) oder der p-Kollektor-Basiszone und der Kathode (K) der Halbleiteranordnung ein aktives Schaltelement (P2) angeordnet ist oder an beiden besagten Stellen aktive Schaltelemente (P1, P2) angeordnet sind.

5. Schalteranordnung nach Anspruch 3) oder 4), **dadurch gekennzeichnet**, daß die Anordnung mit einer beliebigen Kombination oder Auswahl der Schaltelemente (P1, P2, S1, S2) versehen worden ist.

6. Schalteranordnung nach Anspruch 1) bis 5), **dadurch gekennzeichnet**, daß passive Ableitelemente (Q1, Q2), die aus einer beliebigen Kombination von konzentrierten oder verteilten, linearen oder nichtlinearen Widerständen, Induktivitäten oder Kapazitäten oder daraus aufgebauten Netzwerken bestehen, parallel zu den Emitter-Basisstrecken der Transistoren (T1, T2) oder der Anode (A) und der n-Kollektor-Basiszone und/oder der p-Kollektor-Basiszone und der Kathode (K) der Halbleiteranordnung angeordnet sind.

7. Schalteranordnung nach Anspruch 4), **dadurch gekennzeichnet**, daß passive Impedanzen (RS1, RS2), die aus einer beliebigen Kombination von konzentrierten oder verteilten, linearen oder nichtlinearen Widerständen, Induktivitäten oder Kapazitäten oder daraus aufgebauten Netzwerken bestehen, in der Zuleitung vom zweiten Verbindungspunkt (N1) zur Basis des pnp-Transistors (T1) und/oder der Zuleitung vom ersten Verbindungspunkt (N2) zur Basis des npn-Transistors (T2) angeordnet sind.

**8.** Schalteranordnung nach Ansprüchen 1) bis 7), **dadurch gekennzeichnet**, daß zwei Schalteranordnungen als Halbbrücke direkt miteinander in Reihe geschaltet sind, sodaß die Anode der einen Schalteranordnung (SA1) mit dem positiven Pol, die Kathode der anderen Schalteranordnung (SA2) mit dem negativen Pol einer Spannungsversorgung verbunden ist und daß eine Last (L), die zwischen dem gemeinsamen Verbindungspunkt der Schalteranordnungen und einem der Anschlüsse der Spannungsversorgung angeordnet ist, abwechselnd mit dem positiven und dem negativen Pol der Spannungsversorgung verbunden wird, wenn die Schalteranordnungen abwechselnd schließen und öffnen.

**9.** Schalteranordnung nach Anspruch 8), **dadurch gekennzeichnet**, daß die Basen der beiden direkt mit der Last verbundenen Transistoren (T2, T3) oder die entsprechenden Steuerelektroden der Halbleiteranordnungen in den beiden Schalteranordnungen (SA1, SA2) durch eine Verbindung (BC) direkt miteinander verbunden sind.

**10.** Schalteranordnung nach Anspruch 8) oder 9), **dadurch gekennzeichnet**, daß je zwei Halbbrücken parallel so zu einer Vollbrücke verschaltet sind, daß eine zwischen den Mittelpunkten der beiden Halbbrücken angeordnete Last (L) mit abwechselnder Polarität mit den beiden Polen einer Spannungsversorgung verbunden wird, wenn eine der Halbbrükken abwechselnd zum ersten und zweiten Pol, die andere Halbbrücke zum zweiten und ersten Pol der Spannungsversorgung durchschaltet.

**Claims**

**1.** Switching arrangement with transistors based on regenerative current feedback, comprising a pnp-transistor (T1) and an npn-transistor (T2) where the emitter of the pnp-transistor represents the anode and the emitter of the npn-transistor represents the cathode, the collector of the pnp-transistor being connected via a first node (N2) with the base of the npn-transistor, the collector of the npn-transistor being connected via a second node (N1) with the base of the pnp-transistor and a diode (SD) connected to the two nodes (N1,N2) such that the anode of the diode (SD) is directly connected with the collector of the pnp-transistor (T1) and the cathode of the diode is directly connected with the collector of the npn-transistor (T2), characterized in that the forward voltage of the diode (SD) is substantially less than the forward voltage of one of the pn- or np-junctions of the transistors (T1,T2).

**2.** Switching arrangement according to claim 1, characterized in that it consists of a semiconductor arrangement of four zones of alternate conduction type including a p-emitter zone representing the anode (A), an inner n-base-collector zone which can be contacted and brought out as a first control gate electrode (G1), an inner p-base-collector zone which can be contacted and brought out as the second control gate electrode (G2), and an n-emitter zone representing the cathode (K), where the diode (SD) with its anode connected to the inner p-base-collector zone and its cathode connected to the inner n-base-collector zone can either be connected externally to the control gate electrodes (G1,G2) or be integrated directly into the semiconductor crystal structure.

**3.** Switching arrangement according to claim 1, characterized in that it further comprises at least one of the following: an active switching element (S2) connected between the first node (N2) and the base of the npn-transistor (T2) and an active switching element (S1) connected between the second node (N1) and the base of the pnp-transistor (T1)

**4.** Switching arrangement according to claim 1 or 2, characterized in that it further comprises at least one of the following: an active switching element (P1) connected between the base and the emitter of pnp-transistor (T1) and an active switching element (P2) connected between the base and the emitter of npn-transistor (T2).

**5.** Switching arrangement according to claim 3 or 4, characterized in that it further comprises a random combination or selection of active switching elements (P1, P2, S1, S2).

**6.** Switching arrangement according to claims 1 to 5, characterized in that it further comprises at least one of the following: a passive shunt element (Q1) connected between the base and the emitter of pnp-transistor (T1) and a passive shunt element (Q2) connected between the base and the emitter of npn-transistor (T2) wherein said passive shunt elements (Q1, Q2) include any combination of lumped or distributed, linear or nonlinear resistors, inductors or capacitors or of networks composed thereof.

**7.** Switching arrangement according to claim 4, characterized in that it further comprises at least one of the following: a first passive impedance (RS2) connected between the first node (N2) and the base of the npn-transistor (T2) and a second passive impedance (RS1) connected between the second node (N1) and the base of the pnp-transistor (T1) wherein said first and second passive impedances include any combination of lumped or distributed, linear or nonlinear resistors, inductors or capacitors or of networks composed thereof.

8. Switching arrangement according to claims 1 to 7, characterized in that it consists of two switching circuits or of semiconductor arrangements of four zones each (SA1, SA2) being connected in series directly to form a half-bridge configuration where the anode of the first switching circuit (SA1) is connected to the positive pole of a voltage supply and the cathode of the second switching circuit (SA2) is connected to the negative pole of said voltage supply, the cathode of the first switching circuit being connected to the anode of the second switching circuit, and a load (L) connected with its first terminal both to the cathode of the first switching circuit and the anode of the second switching circuit and with its second terminal to either terminal of the voltage supply, said load being switched alternately to the positive and negative pole of the voltage supply whenever the two switches (SA1, SA2) turn on and off alternately.

9. Switching arrangement according to claim 8, characterized in that it further comprises a direct connection (BC) between the bases of the transistors (T2,T3) or between the control gate (G2) of semiconductor arrangement (SA1) and the control gate (G1) of semiconductor arrangement (SA2).

10. Switching arrangement according to claim 8 or 9, characterized in that it further comprises two of said half-bridge circuits being connected in parallel to form a full bridge circuit such that a load (L) is connected across the center connections of the two half-bridge circuits wherein the load will be switched alternately to the two poles of the voltage supply if the two half-bridges switch alternately to the positive or negative pole of the voltage supply.

**Revendications**

1. Arrangement de commutation avec transistors et réaction regénérative de courant, se composant d'un transistor PNP (T1) et d'un transistor NPN (T2), où l'émetteur du transistor PNP (T1) constitue l'anode et l'émetteur du transistor NPN (T2) la cathode, de par ailleurs le collecteur du transistor PNP (T1) est relié via le premier noeud (N2) à la base du transistor NPN (T2), ainsi que le collecteur du transistor NPN (T2) est relié via le deuxième noeud (N1) à la base du transistor PNP (T1), et d'une diode (SD) dont l'anode est connectée au collecteur du transistor PNP (T1) et la cathode au collecteur du transistor NPN (T2), caractérisé en ce que la tension de passage de la diode (SD) est substantiellement inférieure à la tension de passage d'un des jonctions PN ou NP d'un des transistors NPN (T2) ou PNP (T1).

2. Arrangement de commutation selon la revendication 1), caractérisé en ce qu'il se compose d'un arrangement du semi-conducteur constitué de quatre zones alternées de type opposé, avec une zone émetteur externe de type P considérée comme l'anode (A), une zone base-collecteur interne de type N qui peut être reliée comme point de sortie en tant que première electrode de commande (G1), une zone base-collecteur interne de type P qui peut être reliée comme point de sortie en tant que deuxième electrode de commande (G2), et une zone émetteur externe de type N considérée comme cathode (K), où la diode (SD), dont la cathode est reliée avec la zone interne base-collecteur de type N et l'anode avec la zone interne base-collecteur de type P, peut être: soit raccordée aux deux électrodes de commande (G1,G2), soit intégrée directement au niveau des cristaux respectivement entre les deux zones internes semi-conducteurs.

3. Arrangement de commutation selon la revendication 1), caractérisé en ce qu'un élément actif de commutation est connecté: soit entre le premier noeud (N2) et la base du transistor NPN (T2), dénommé (S2), soit entre le deuxième noeud (N1) et la base du transistor NPN (T1), dénommé (S1), ou dans les deux cas cités ci-dessus, dénommé (S1,S2).

4. Arrangement de commutation selon la revendication 1) ou 2), caractérisé en ce qu'un élément actif de commutation (P1) est connecté: entre la base et l'émetteur du transistor PNP (T1) ou entre l'anode (A) et la zone N base-collecteur de l'arrangement du semi-conducteur, ou en ce qu'un élément actif de commutation (P2) est connecté: entre la base et l'émetteur du transistor NPN (T2) ou entre la zone P collecteur-base et la cathode (K) de l'arrangement du semi-conducteur, ou en ce que deux éléments actifs dénommé (P1,P2) sont connectés dans les deux cas cités ci-dessus.

5. Arrangement de commutation selon la revendication 1) ou 2), caractérisé en ce qu'une libre combination ou choix des eléments actifs de commutation (S1,S2,P1,P2) est appliquée.

6. Arrangement de commutation selon les revendications 1) à 5), caractérisé en ce que au moins un d'éléments passifs de dérivation (Q1) ou (Q2), étant réalisés d'une libre combination de composants tels que résistances, condensateurs et inductances, intégrés ou non, linéaires ou non, ou d'un réseau formé de ces composants, est connecté: soit entre la base et l'émetteur des transistors (T1) ou (T2), soit entre l'anode (A) et la zone N base-collecteur ou entre la zone P base-collecteur et la cathode (K) de l'arrangement du semi-conducteur.

7. Arrangement de commutation selon la revendication 4), caractérisé en ce que au moins une des impédances passives (RS1) ou (RS2), étant réalisées d'une libre combinaison de composants tels que résistances, condensateurs et inductances, intégrés ou non, linéaires ou non, ou d'un réseau formé de ces composants, est connectée: soit entre le deuxième noeud (N1) et la base du transistor PNP (T1), soit entre le premier noeud (N2) et la base du transistor NPN (T2), ou dans les deux cas cités ci-dessus.

8. Arrangement de commutation selon les revendications 1) à 7) caractérisé en ce que deux arrangements de commutation (SA1, SA2), sont connectés en série pour réaliser une branche du demi-pont tel que: l'anode d'un des deux arrangements (SA1) est reliée au pôle positif d'une alimentation électrique et la cathode de l'autre arrangement (SA2) au pôle négatif de l'alimentation, ainsi qu'une charge (L), connectée entre la jonction commune de la configuration et une des bornes d'alimentation étant reliée alternativement aux pôles positive et négative de l'alimentation lorsque les arrangements de commutation (SA1, SA2) citées ci-dessus permutent alternativement.

9. Arrangement de commutation selon la revendication 8) caractérisé en ce que les bases des transistors (T2,T3) connectés directement avec la charge ou les électrodes de commande respectives des arrangements du semi-conducteur sont reliées ensemble par un raccordement direct (BC) au niveau des deux arrangements (SA1,SA2).

10. Arrangement de commutation selon la revendication 8) ou 9) caractérisé en ce que deux branches du demi-pont sont connectées en parallèle pour former un pont entier de telle sorte qu'une charge (L), reliée entre les jonctions communes des demi-ponts, sera commutée alternativement à la borne positive ou à la borne négative de l'alimentation électrique, lorsque l'un des demi-ponts commute alternativement entre la première et deuxième borne, et l'autre commute alternativement entre la deuxième et la première borne de l'alimentation.

FIG. 1A

FIG. 2A

FIG. 2C

FIG. 1B

FIG. 2B

FIG. 3

FIG. 4

FIG. 5

FIG. 6

FIG. 7

FIG. 8

FIG. 9

FIG. 10

FIG. 11

FIG. 12

FIG. 13